# EUROPEAN PATENT SPECIFICATION

(11) **EP 4 050 977 B1**
(45) Date of publication and mention of the grant of the patent: **19.03.2025**
(21) Application number: 21217308.2
(22) Date of filing: 23.12.2021
(51) Int. Cl.: H05K 7/14, H02J 3/38, H02B 7/06

(54) **INVERTING AND BOOSTING DEVICE AND POWER GENERATION SYSTEM**
INVERTIERENDE UND VERSTÄRKENDE VORRICHTUNG UND STROMERZEUGUNGSSYSTEM
DISPOSITIF D'INVERSION ET D'AMPLIFICATION ET SYSTÈME DE GÉNÉRATION DE PUISSANCE

(30) Priority: 26.02.2021 CN 202120435742 U
(43) Date of publication of application: 31.08.2022
(73) Proprietor: Sungrow Power Supply Co., Ltd., Hefei, Anhui 230088 (CN)
(72) Inventor: YAN, Longxiang, Hefei (CN); ZHU, Qiyao, Hefei (CN); ZHANG, Xianwei, Hefei (CN)
(74) Representative: Rooney, John-Paul

(56) References cited:
- WO-A1-2019/088550
- CN-A- 108 288 834
- CN-A- 108 306 613
- CN-U- 205 944 805
- CN-U- 207 651 856
- CN-U- 209 298 901
- GB-A- 2 500 196

## Description

### FIELD

The present disclosure relates to the technical field of power generation, and in particular to an inverting and boosting device and a power generation system.

### BACKGROUND

In a photovoltaic power generation system, direct-current (DC) power generated by a solar panel is converted by an inverting and boosting device for use. The inverting and boosting device mainly includes two inverters and a boost device. The inverters convert the DC power generated by the solar panel into alternating-current (AC) power, and the boost device boosts the AC power for use.

Currently, the boost device mainly includes a transformer and a ring main unit. The inverters are electrically connected with a low-voltage side of the transformer, and the ring main unit is electrically connected with a high-voltage side of the transformer. The two inverters and the transformer are arranged in a triangle, and thus it is difficult to connect the inverters with the transformer. Furthermore, long cables are required, resulting in high cost.

In addition, the transformer, the ring main unit and the inverters each are independent devices, and thus are installed independently at an installation site, so that the boost device is required to be electrically connected with the inverters at the installation site, resulting in complex installation. Moreover, it is required to perform the commissioning on the installation site, resulting in high commissioning cost.

In addition, the transformer, the ring main unit and the inverters each are independent devices, and thus are transported independently, resulting in high transportation cost, especially the high marine transportation cost.

In addition, since the transformer, the ring main unit and the inverters are installed independently on the installation site, the installation site is required to have a large foundation area, resulting in high foundation construction cost.

For example, CN205944805U, CN209298901U, CN207651856U, CN108288834A, CN108306613A all disclose that all inverters are arranged on the same side of the transformer, which form a triangle structure. WO 2019/088550 discloses that all inverters are arranged on the same side of the transformer, but form a linear structure. GB2500196A discloses that all inverter are integrated into an inverter module. In summary, it is desired to solve the problem of how to design the inverting and boosting device to reduce the difficulty of installation and reduce the cost.

### SUMMARY

In view of above, an inverting and boosting device is provided in the present disclosure, to reduce difficulty of the installation and cost. In addition, a power generation system including the above inverting and boosting device is provided in the present disclosure. The invention is as defined in the appended set of claims.

### BRIEF DESCRIPTION OF THE DRAWINGS

Figure 1 is a schematic structural diagram of an inverting and boosting device according to an embodiment of the present disclosure;
Figure 2 is a top view of an inverting and boosting device according to an embodiment of the present disclosure; and
Figure 3 is a schematic structural diagram of a transformer in an inverting and boosting device according to an embodiment of the present disclosure.

### DETAILED DESCRIPTION

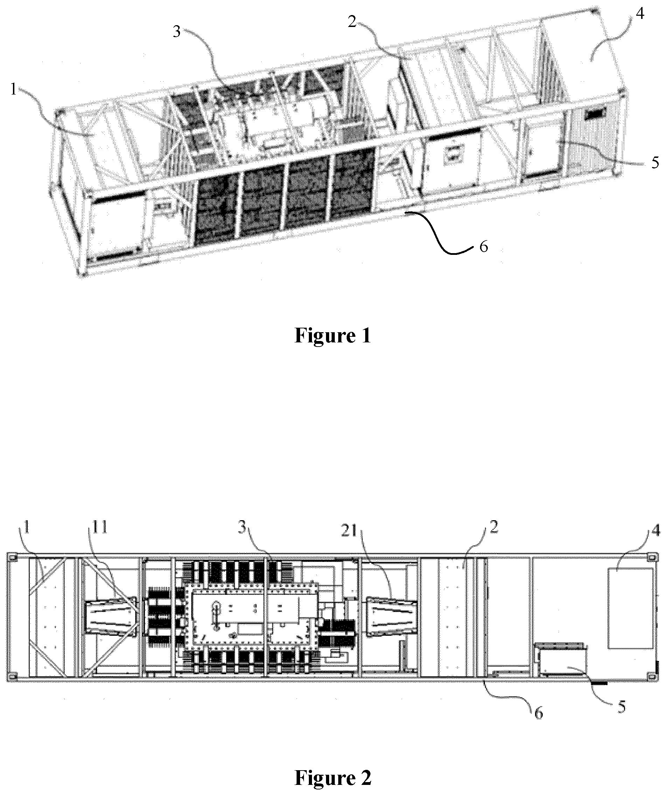

As shown in Figures 1 and 2, according to the present invention, an inverting and boosting device includes a first inverter 1, a second inverter 2, a transformer 3 and a ring main unit 4 electrically connected with a high-voltage side of the transformer 3. The first inverter 1 is electrically connected with a first low-voltage side 31 of the transformer 3. The first inverter 1 and the first low-voltage side 31 are arranged on a same side of the transformer 3. The second inverter 2 is electrically connected with a second low-voltage side 32 of the transformer 3. The second inverter 2 and the second low-voltage side 32 are arranged on a same side of the transformer 3.

The number of the first inverter 1 and the number of the second inverter 2 are determined according to the actual requirements. In some embodiments, the number of the first inverter 1 and the number of the second inverter 2 each are one, so as to simplify a structure and reduce cost. Alternatively, the number of the first inverter 1 and the number of the second inverter 2 each may be determined as two or more according to the actual requirements, which are not limited in the embodiment.

In the inverting and boosting device according to the embodiment of the present disclosure, the first inverter 1 and the first low-voltage side 31 are arranged on a same side of the transformer 3, and the second inverter 2 and the second low-voltage side 32 are arranged on a same side of the transformer 3, so that the first inverter 1 is face to face with the first low-voltage side 31, and the second inverter 2 is face to face with the second low-voltage side 32, thereby reducing the difficulty of connecting the first inverter 1 with the transformer 3 and the difficulty of connecting the second inverter 2 with the transformer 3, and effectively reducing a length of a required cable and the cost.

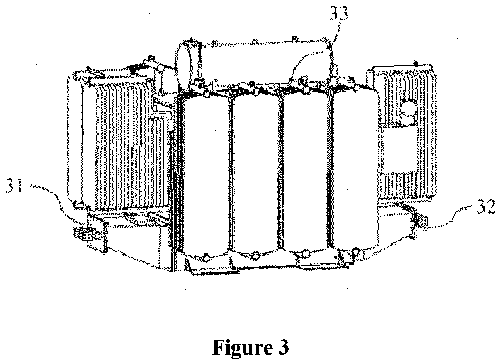

In some embodiments, in order to reduce the total length of the inverting and boosting device in a direction, in the transformer 3, the first low-voltage side 31 and the second low-voltage side 32 are respectively arranged on two opposite sides of a fuel tank 33, as shown in Figure 3. It is understood that in accordance with the claimed invention, the first low-voltage side 31 and the second low-voltage side 32 are respectively arranged on two opposite sides of the transformer 3. Therefore, the first inverter 1 and the second inverter 2 are respectively arranged on two opposite sides of the transformer 3. By the structure described above, the compactness of the inverting and boosting device can be improved and the volume of the inverting and boosting device can be reduced, while facilitating the connection of the transformer 3 and the first inverter 1 and the connection of the transformer 3 and the second inverter 2.

In practices, relative positions of the first low-voltage side 31, the second low-voltage side 32 and the fuel tank 33 may be changed according to the actual requirements, which is not limited to the above embodiment.

In the above inverting and boosting device, a first AC output end 11 of the first inverter 1 is electrically connected with the first low-voltage side 31, and a second AC output end 21 of the second inverter 2 is electrically connected with the second low-voltage side 32. The first AC output end 11 of the first inverter 1 faces towards the first low-voltage side 31, and the second AC output end 21 of the second inverter 2 faces towards the second low-voltage side 32, as shown in Figure 2. In this way, the connection of the first inverter 1 and the transformer 3 and the connection of the second inverter 2 and the transformer 3 can be performed without being affected by other components and without displacement, which facilitates the connection and reduces the length of required cable.

In the above inverting and boosting device, the position of the ring main unit 4 is determined according to the actual requirements. In some embodiments, in order to facilitate the connection, the ring main unit 4 is arranged on a side of the second inverter 2 that is away from the transformer 3. Alternatively, the ring main unit 4 may be arranged on a side of the first inverter 1 that is away from the transformer 3. Alternatively, the ring main unit 4 may be arranged on other positions, which is not limited to the above embodiment.

The inverting and boosting device includes an auxiliary power distribution device 5. The auxiliary power distribution device 5 includes an auxiliary power distribution module and a communication module. Each of the first inverter 1 and the second inverter 2 is in electrical connection with and in communication connection with the auxiliary power distribution device 5. Each of the transformer 3 and the ring main unit 4 is in electrical connection with and in communication connection with the auxiliary power distribution device 5. The structures and forms of the electrical connection and the communication connection are determined according to the actual requirements, which are not limited in the embodiment.

Since the ring main unit 4 is a high-voltage device and the auxiliary power distribution device 5 is a low-voltage device, the auxiliary power distribution device 5 is preferably arranged outside the ring main unit 4, that is, the auxiliary power distribution device 5 is separated from the ring main unit 4. Therefore, the high-voltage device is separated from the low-voltage device, which improves the security and facilitates overhaul of the auxiliary power distribution device 5 and the ring main unit 4.

In some embodiments, in a case that the ring main unit 4 is arranged on the side of the second inverter 2 that is away from the transformer 3, the auxiliary power distribution device 5 is arranged between the second inverter 2 and the ring main unit 4, to facilitate the connection. Further, the auxiliary power distribution device 5 is close to the ring main unit 4 to facilitate the connection of the auxiliary power distribution device 5 and the ring main unit 4.

In practices, the auxiliary power distribution device 5 may be arranged on other positions. For example, the auxiliary power distribution device 5 may be arranged on a position close to the first inverter 1, which is not limited to the above embodiments.

In some embodiments, the transformer 3 is provided with a protection net door capable of opening and closing, which not only facilitates the maintenance and overhaul, but also ensures the heat dissipation. Furthermore, the protection can be achieved to meet the on-site safety requirements.

The number of the protection net door is determined according to the requirement on maintenance and heat dissipation. In some embodiments, the number of the protection net doors is at least two, and the protection net doors cover some or all sides of the transformer 3.

For example, the transformer 3 is in a shape of cuboid, and the protection net doors cover four sides of the transformer 3. In practices, the transformer 3 may be in other shapes, which is not limited in the embodiment.

In practices, the transformer 3 may be provided with a protection net on each side. The protection net may be partially or completely a protection net door capable of opening and closing.

In order to maintain and overhaul the first inverter 1 and the second inverter 2, the first inverter 1 is provided with a first door plate capable of opening and closing, and the second inverter 2 is provided with a second door plate capable of opening and closing. The number of the first door panel and the number of the second door panel are determined according to the actual requirements. In some embodiments, the number of the first door panel is at least two, and the first door panels cover some or all sides of the first inverter 1. The number of the second door panel is at least two, and the second door panels cover some or all sides of the second inverter 2.

In some embodiments, the first inverter 1 and the second inverter 2 are in the shape of cuboid. The first door panels cover four sides of the first inverter 1, and the second door panels cover four sides of the second inverter 2. In practices, the first inverter 1 and the second inverter 2 may be in other shapes, which are not limited in the embodiment.

In order to further improve the above technical solution, the inverting and boosting device further includes a rack. The first inverter 1, the second inverter 2, the transformer 3, the ring main unit 4 and the auxiliary power distribution device 5 of the inverting and boosting device are integrated on the rack 6, so that the first inverter 1, the second inverter 2, the transformer 3, the ring main unit 4 and the auxiliary power distribution device 5 are integrated as an independent inverting and boosting device. In a process of on-site installation, only the whole inverting and boosting device needs to be installed, rather than separately installing the first inverter 1, the second inverter 2, the transformer 3, the ring main unit 4 and the auxiliary power distribution device 5 and connecting them together, so as to simplify the on-site installation. In addition, the first inverter 1, the second inverter 2, the transformer 3, the ring main unit 4 and the auxiliary power distribution device 5 needs not to be commissioned independently, so as to reduce the on-site commissioning cost.

In addition, the integrated inverting and boosting device is transported as a whole, rather than separately transporting the first inverter 1, the second inverter 2, the transformer 3, the ring main unit 4 and the auxiliary power distribution device 5, so as to effectively reduce the transportation cost, especially the marine transportation cost. Moreover, compared with separately installing the boost device and the inverters in the conventional technology, the installation of the inverting and boosting device as a whole requires a less foundation area of the installation site, thereby reducing the foundation construction cost.

In the inverting and boosting device, in a case that the transformer 3 is provided with the protection net door, the rack 6 has an opening for exposing the protection net door. In a case that the first inverter 1 is provided with the first door panel, the rack 6 has an opening for exposing the first door panel. In a case that the second inverter 2 is provided with the second door panel, the rack 6 has an opening for exposing the second door panel.

In order to improve the compactness, the first inverter 1, the transformer 3, the second inverter 2, the auxiliary power distribution device 5 and the ring main unit 4 are sequentially arranged along a length direction of the rack 6, facilitating maintenance and overhaul of each device.

In order to facilitate the maintenance and overhaul of the ring main unit 4, the ring main unit 4 is arranged at an end of the rack 6, and an operating surface of the ring main unit 4 faces towards outside the rack 6. The operating surface of the ring main unit 4 is parallel to a width direction of the rack 6 and perpendicular to the length direction of the rack 6. In this way, the operation surface of the ring main cabinet 4 can be manipulated directly from the outside of the rack 6, facilitating the maintenance.

In the inverting and boosting device, the shape of the rack 6 is determined according to the actual requirements. For example, the rack 6 is in a shape of cuboid, cylinder or the like, which is not limited in the embodiment. In some embodiments, in order to simplify the structure and facilitate transportation, the rack 6 is in the shape of cuboid. It is understood that the rack 6 may have an open structure, rather than a closed structure. Alternatively, the rack 6 may have a closed structure, which however is not convenient for maintenance and heat dissipation.

In some embodiments, in order to facilitate transportation, the rack 6 is in the shape of cuboid having a same size as a standard container. There are various sizes of standard containers. One of the sizes may be selected as the size of the rack 6 according to the actual requirements. The rack 6 has a same length as the standard container, a same width as the standard container, and a same height as the standard container.

In practices, the rack 6 may have another size and may be in another shape, which are not limited to the above embodiment.

Based on the inverting and boosting device according to the above embodiments, a power generation system is further provided according to an embodiment. The power generation system includes the inverting and boosting device as described in any of the above embodiments.

Since the power generation system includes the inverting and boosting device, the power generation system also has the same technical effects as the inverting and boosting device, which are not repeated herein.

The power generation system may be any type of power generation system as required. For example, the power generation system is a photovoltaic power generation system, which is not limited in the embodiment.

## Claims

1. An inverting and boosting device, comprising:
a first inverter (1),
a second inverter (2),
a transformer (3), and
a ring main unit (4) electrically connected with a high-voltage side of the transformer (3), wherein
a first alternating-current (AC) output end (11) of the first inverter (1) is electrically connected with a first low-voltage side (31) of the transformer (3), and the first inverter (1) and the first low-voltage side (31) are arranged on a same side of the transformer (3); and
a second AC output end (21) of the second inverter (2) is electrically connected with a second low-voltage side (32) of the transformer (3), and the second inverter (2) and the second low-voltage side (32) are arranged on a same side of the transformer (3),
wherein the inverting and boosting device is **characterized in that** the first low-voltage side (31) and the second low-voltage side (32) are respectively arranged on two opposite sides of the transformer (3), the first inverter (1) and the second inverter (2) are respectively arranged on the two opposite sides of the transformer (3), the first AC output end (11) faces towards the first low-voltage side (31), and the second AC output end (21) faces towards the second low-voltage side (32).

2. The inverting and boosting device according to claim 1, wherein
the ring main unit (4) is arranged on a side of the second inverter (2) that is away from the transformer (3).

3. The inverting and boosting device according to claim 1, wherein
an auxiliary power distribution device (5) of the inverting and boosting device is arranged outside the ring main unit (4).

4. The inverting and boosting device according to claim 3, wherein
the ring main unit (4) is arranged on a side of the second inverter (2) that is away from the transformer (3), and the auxiliary power distribution device (5) is arranged between the second inverter (2) and the ring main unit (4).

5. The inverting and boosting device according to claim 1, wherein
the transformer (3) is provided with a protection net door capable of opening and closing.

6. The inverting and boosting device according to claim 1, wherein
the first inverter (1) is provided with a first door plate capable of opening and closing; and
the second inverter (2) is provided with a second door plate capable of opening and closing.

7. The inverting and boosting device according to any one of claims 1 to 5, further comprising a rack, wherein
the first inverter (1), the second inverter (2), the transformer (3), the ring main unit (4) and an auxiliary power distribution device (5) of the inverting and boosting device are integrated on the rack (6).

8. The inverting and boosting device according to claim 7, wherein
the first inverter (1), the transformer (3), the second inverter (2), the auxiliary power distribution device (5) and the ring main unit (4) are sequentially arranged along a length direction of the rack (6).

9. The inverting and boosting device according to claim 8, wherein
the ring main unit (4) is arranged at an end of the rack (6), an operating surface of the ring main unit (4) faces towards outside the rack (6), and the operating surface of the ring main unit (4) is parallel to a width direction of the rack (6) and perpendicular to the length direction of the rack (6).

10. The inverting and boosting device according to claim 7, wherein
the rack (6) is in a shape of cuboid, and the rack (6) has a same size as a standard container.

11. A power generation system, comprising the inverting and boosting device according to any one of claims 1 to 10.

## Patentansprüche

1. Wechselrichter- und Verstärkungsvorrichtung, umfassend:
einen ersten Wechselrichter (1),
einen zweiten Wechselrichter (2),
einen Transformator (3), und
eine Ring Main Unit (4), die elektrisch mit einer Hochspannungsseite des Transformators (3) verbunden ist, wobei
ein erstes Wechselstrom(AC)-Ausgangsende (11) des ersten Wechselrichters (1) elektrisch mit einer ersten Niederspannungsseite (31) des Transformators (3) verbunden ist, und der erste Wechselrichter (1) und die erste Niederspannungsseite (31) auf einer gleichen Seite des Transformators (3) angeordnet sind; und
ein zweites AC-Ausgangsende (21) des zweiten Wechselrichters (2) elektrisch mit einer zweiten Niederspannungsseite (32) des Transformators (3) verbunden ist, und der zweite Wechselrichter (2) und die zweite Niederspannungsseite (32) auf einer gleichen Seite des Transformators (3) angeordnet sind,
wobei die Wechselrichter- und Verstärkungsvorrichtung **dadurch gekennzeichnet ist, dass** die erste Niederspannungsseite (31) und die zweite Niederspannungsseite (32) jeweils auf zwei gegenüberliegenden Seiten des Transformators (3) angeordnet sind, der erste Wechselrichter (1) und der zweite Wechselrichter (2) jeweils auf den beiden gegenüberliegenden Seiten des Transformators (3) angeordnet sind, das erste AC-Ausgangsende (11) in Richtung der ersten Niederspannungsseite (31) zeigt und das zweite AC-Ausgangsende (21) in Richtung der zweiten Niederspannungsseite (32) zeigt.

2. Wechselrichter- und Verstärkungsvorrichtung nach Anspruch **1,** wobei
die Ring Main Unit (4) auf einer Seite des zweiten Wechselrichters (2) angeordnet ist, die vom Transformator (3) abgewandt ist.

3. Wechselrichter- und Verstärkungsvorrichtung nach Anspruch **1,** wobei
eine Hilfsleistungsverteilungsvorrichtung (5) der Wechselrichter- und Verstärkungsvorrichtung außerhalb der Ring Main Unit (4) angeordnet ist.

4. Wechselrichter- und Verstärkungsvorrichtung nach Anspruch 3, wobei
die Ring Main Unit (4) auf einer Seite des zweiten Wechselrichters (2) angeordnet ist, die vom Transformator (3) abgewandt ist, und die Hilfsleistungsverteilungsvorrichtung (5) zwischen dem zweiten Wechselrichter (2) und der Ring Main Unit (4) angeordnet ist.

5. Wechselrichter- und Verstärkungsvorrichtung nach Anspruch 1, wobei
der Transformator (3) mit einer Schutznetztür versehen ist, die geöffnet und geschlossen werden kann.

6. Wechselrichter- und Verstärkungsvorrichtung nach Anspruch 1, wobei
der erste Wechselrichter (1) mit einer ersten Türplatte versehen ist, die geöffnet und geschlossen werden kann; und
der zweite Wechselrichter (2) mit einer zweiten Türplatte ausgestattet ist, die geöffnet und geschlossen werden kann.

7. Wechselrichter- und Verstärkungsvorrichtung nach einem der Ansprüche 1 bis 5, ferner umfassend ein Gestell, wobei
der erste Wechselrichter (1), der zweite Wechselrichter (2), der Transformator (3), die Ring Main Unit (4) und die Hilfsleistungsverteilungsvorrichtung (5) der Wechselrichter- und Verstärkungsvorrichtung auf dem Gestell (6) integriert sind.

8. Wechselrichter- und Verstärkungsvorrichtung nach Anspruch 7, wobei
der erste Wechselrichter (1), der Transformator (3), der zweite Wechselrichter (2), die Hilfsleistungsverteilungsvorrichtung (5) und die Ring Main Unit (4) sequenziell entlang einer Längenrichtung des Gestells (6) angeordnet sind.

9. Wechselrichter- und Verstärkungsvorrichtung nach Anspruch 8, wobei
die Ring Main Unit (4) an einem Ende des Gestells (6) angeordnet ist, eine Betriebsfläche der Ring Main Unit (4) zur Außenseite des Gestells (6) zeigt und die Betriebsfläche der Ring Main Unit (4) parallel zu einer Breitenrichtung des Gestells (6) und senkrecht zu der Längenrichtung des Gestells (6) ist.

10. Wechselrichter- und Verstärkungsvorrichtung nach Anspruch 7, wobei
das Gestell (6) in Form eines Quaders vorliegt, und das Gestell (6) die gleiche Größe wie ein Standardcontainer aufweist.

11. Leistungserzeugungssystem, umfassend die Wechselrichter- und Verstärkungsvorrichtung nach einem der Ansprüche 1 bis 10.

## Revendications

1. Dispositif onduleur et amplificateur, comprenant :
un premier onduleur (1),
un deuxième onduleur (2),
un transformateur (3), et
une unité principale d'anneau (4) connectée électriquement à un côté haute tension du transformateur (3), dans lequel
une première extrémité de sortie de courant alternatif (CA) (11) du premier onduleur (1) est connectée électriquement à un premier côté basse tension (31) du transformateur (3), et le premier onduleur (1) et le premier côté basse tension (31) sont disposés sur un même côté du transformateur (3) ; et
une deuxième extrémité de sortie CA (21) du deuxième onduleur (2) est connectée électriquement à un deuxième côté basse tension (32) du transformateur (3), et le deuxième onduleur (2) et le deuxième côté basse tension (32) sont disposés sur un même côté du transformateur (3),
dans lequel le dispositif onduleur et amplificateur est **caractérisé en ce que** le premier côté basse tension (31) et le deuxième côté basse tension (32) sont disposés respectivement sur deux côtés opposés du transformateur (3), le premier onduleur (1) et le deuxième onduleur (2) sont disposés respectivement sur les deux côtés opposés du transformateur (3), la première extrémité de sortie CA (11) fait face au premier côté basse tension (31) et la deuxième extrémité de sortie CA (21) fait face au deuxième côté basse tension (32).

2. Dispositif onduleur et amplificateur selon la revendication 1, dans lequel
l'unité principale d'anneau (4) est disposée sur un côté du deuxième onduleur (2) éloigné du transformateur (3).

3. Dispositif onduleur et amplificateur selon la revendication 1, dans lequel
un dispositif de distribution d'énergie auxiliaire (5) du dispositif onduleur et amplificateur est disposé à l'extérieur de l'unité principale d'anneau (4).

4. Dispositif onduleur et amplificateur selon la revendication 3, dans lequel
l'unité principale d'anneau (4) est disposée sur un côté du deuxième onduleur (2) éloigné du transformateur (3), et le dispositif de distribution d'énergie auxiliaire (5) est disposé entre le deuxième onduleur (2) et l'unité principale d'anneau (4).

5. Dispositif onduleur et amplificateur selon la revendication 1, dans lequel
le transformateur (3) est pourvu d'une porte à filet de protection pouvant s'ouvrir et se fermer.

6. Dispositif onduleur et amplificateur selon la revendication 1, dans lequel
le premier onduleur (1) est pourvu d'une première plaque de porte pouvant s'ouvrir et se fermer ; et
le deuxième onduleur (2) est pourvu d'une deuxième plaque de porte pouvant s'ouvrir et se fermer.

7. Dispositif onduleur et amplificateur selon l'une quelconque des revendications 1 à 5, comprenant en outre un rack, dans lequel
le premier onduleur (1), le deuxième onduleur (2), le transformateur (3), l'unité principale d'anneau (4) et un dispositif de distribution d'énergie auxiliaire (5) du dispositif onduleur et amplificateur sont intégrés sur le rack (6) .

8. Dispositif onduleur et amplificateur selon la revendication 7, dans lequel
le premier onduleur (1), le transformateur (3), le deuxième onduleur (2), le dispositif de distribution d'énergie auxiliaire (5) et l'unité principale d'anneau (4) sont disposés séquentiellement le long d'une direction de longueur du rack (6).

9. Dispositif onduleur et amplificateur selon la revendication 8, dans lequel
l'unité principale d'anneau (4) est disposée à une extrémité du rack (6), une surface de fonctionnement de l'unité principale d'anneau (4) est orientée vers l'extérieur du rack (6), et la surface de fonctionnement de l'unité principale d'anneau (4) est parallèle à une direction de largeur du rack (6) et perpendiculaire à la direction de longueur du rack (6).

10. Dispositif onduleur et amplificateur selon la revendication 7, dans lequel
le rack (6) a la forme d'un parallélépipède, et le rack (6) a la même taille qu'un contenant standard.

11. Système de génération d'énergie, comprenant le dispositif onduleur et amplificateur selon l'une quelconque des revendications 1 à 10.
